# EUROPEAN PATENT SPECIFICATION

(11) **EP 3 662 176 B1**
(45) Date of publication and mention of the grant of the patent: **02.06.2021**
(21) Application number: 18768823.9
(22) Date of filing: 05.09.2018
(51) Int. Cl.: F16D 65/12, F16D 61/00

(54) **BRAKE PAD WITH INTEGRATED THERMOELECTRIC ENERGY HARVESTER FOR BRAKING SYSTEM**
BREMSBELAG MIT INTEGRIERTEM THERMOELEKTRISCHEM ENERGIESPEICHER FÜR EIN BREMSSYSTEM
PLAQUETTE DE FREIN À RÉCUPÉRATEUR D'ÉNERGIE THERMOÉLECTRIQUE INTÉGRÉ POUR SYSTÈME DE FREINAGE

(30) Priority: 12.09.2017 IT 201700102064
(43) Date of publication of application: 10.06.2020
(73) Proprietor: ITT Italia S.r.l., 20020 Lainate (IT)
(72) Inventor: SERRA, Stefano, I-12032 Barge (CN) (IT); TRUCCONE, Paolo, I-12032 Barge (CN) (IT); VIGNOLO, Umberto, I-12032 Barge (CN) (IT); ASGHAR ENKESHAFI, Ali, DK-9200 Aalborg SV (DK); AISTRUP ROSENDAHL, Lasse, DK-9210 Aalborg E (DK); VESTERGARD MORTENSEN, Paw, DK-9800 Hjorring (DK); SIN, Agusti, I-12032 Barge (CN) (IT)
(74) Representative: Rapisardi, Mariacristina
(86) International application number: PCT/EP2018/073821
(87) International publication number: WO 2019/052865

(56) References cited:
- WO-A1-2012/041321
- CN-A- 106 246 772
- JP-A- S5 837 329
- US-A1- 2012 000 737

## Description

The present invention relates to a braking pad with integrated thermoelectric energy harvester designed and constructed for use in any brake systems with rotary or linear braking system as well as in a vehicle, windmill, railway, electromotor etc.

The thermoelectric effect is the direct conversion of temperature difference between two sides of the thermoelectric material into electric voltage and vice versa it can create a temperature difference by applying an electric voltage to it.

This effect obtains in some devices made of such materials, usually semiconductors, which is made by many N-type and P-type semiconductor elements. A voltage potential which is proportional to such temperature difference between two sides of the Thermoelectric elements creates whenever a temperature difference is present on the two sides of the semiconductor elements.

The reason of this effect (Seebeck effect) is that the charge carriers diffusing from the hot side of the semiconductor material to the cold side of the material.

A thermoelectric device essentially it is composed of two semiconductor materials, the first one n-doped and the second one p-doped. At the two ends of such semiconductor materials an electrical interconnection is present which can be sometimes integrating also the functionality of heat exchanger, i.e. a material of high thermal conductivity. On the other side two distinct electrical interconnections and heat exchangers divide the p and n side of the device. The two different extremes are then coupled to different thermal source (one cold and a second warm). In this way at the opposite side of the p and n side a voltage difference appears owing to the thermoelectric effect.

If a load is closed between the two sides of the circuit a current is seen to flow and the device behaves like an electric generator.

Thermoelectric devices have been used in several application fields. Brake system are one of a potential application fields for such technology, in view of the fact that friction brakes produce large amounts of thermal energy and thus in principle correspondent amount of electrical energy can be recovered. Just to quote some examples, a vehicle of a mass of 1500 kg braked to stop from an initial speed of 100 km/h, dissipate about 1 MJ by the friction forces, with a consequent significant increase of the internal temperature of the pads. This means that about 1/8 of such thermal energy is distributed among the 8 pads composing a typical braking system of a car, and therefore even if only a very small portion of such energy (4 - 5%) is converted, still the amount of the recovered energy may be large enough to allow meaningful applications. This is the basic reason why a number of R&D activities around the world have been spent to try to recover thermal energy from the friction brakes. The key points for the making of such energy harvesting system are described in the following.

First of all it is relevant the maximization of the efficiency by an effective heat exchange and maximization of the thermal gradient between cold and warm sides by a suitable design.

Then a comparable importance has the definition of a design for Thermo Electric Generator (from now on also referred as TEG) and its integration scheme into a brake pad, that must be easily integrated with minimal impact on the brake pad design and properties, but with a remarkable degree of reliability.

Concerning this latter point often underestimated, it is indeed important to study a TEG module really integrated on a brake pad, since substantial changes in the structure of the brake pad or in the backplate of the brake pad may trigger changes in the NVH behavior (that is to say brake pad Noise, Vibration and Harshness) or in the performances of the brake pad. An invasive approach on the backplate surface on the friction material side may instead induce troubles on the friction material detachment side, both very important and blocking for a real application of the technology. Analyzing some of the most relevant prior art we find different approaches. For instance, JP 58 037329 discloses a solution made of some P&N thermoelectric pellets interconnected in series and forming an array located in a specific structure on the back of the pad and having an electrically insulating layer on the backplate to avoid short circuiting. This solution albeit little invasive is hardly usable in real applications, implying a substantial redesign of a caliper or a pad to account for the remarkable change in thickness of the TEG-modified pad. Besides, a major drawback comes from the little temperature difference expected from the two side of the structure being located on the opposite side with respect friction material (the warm side of the pad) and having a small thickness, having the result to give to the solution a poor efficiency.

JP 11-220804 instead discloses system integrated on a caliper, composed by a heat pipe connected to the caliper and in touch with the thermoelectric generator external to the caliper, and the brake, generally speaking, on the other side in contact with a radiator to provide the cold side of the element. The major drawback of this invention is related to the choice of the caliper as a warm side source, since among the components of a brake systems (rotor, pad and caliper) is the colder with remarkable difference in the maximum temperature achieved, henceforth resulting intrinsically less efficient with respect to solution based on rotors or pads.

WO 2012/041321 A1 relates to a system for recovering waste energy from brake pads of a vessel or a plant and more particularly to a system adapted to use the waste energy to charge a battery or capacitor of the vessel or of the plant.

US 2012/0000737 and WO 2010/109592 disclose a solution for the integration of thermoelectric modules in a pad composed by multiple thermoelectric members integrated onto the back plate on the side of the friction element or in recess of the back plate always on the side of the friction material. Upon such thermoelectric elements cylindrical structure composed by an outer pipe of high friction material and cave inside with the cavity filled up with carbon nanotube materials are disclosed as heat exchangers. The major drawbacks of such solutions are that albeit much improved with respect to the previous in terms of efficiency, still there is room for improvements, in particular because of the limited thermal conductivity of the steel composing the back plate materials with respect to other metal much better performing from this point of view, and also because the thermal gradient is limited to that comprised between the friction material surface and the back plate on the friction material side. Moreover there is still a major issue related to the manufacturability and reliability of such components, being the thermoelectric modules integrated on the surface of the back plate of the pad and henceforth are exposed to the intense pressure and forces during the manufacturing process and the operating conditions of the brake pad, where pressure can reach up to 400 bar and over. Last but not least, in the configuration with the recesses on the back plate, different behaviors on the NVH properties of the pad can be induced, moreover severe detachment issues of the friction material due to adhesion problems can occur.

As a last analyzed case, Aalborg University disclosed a thermoelectric generator brake pad, comprising thermoelectric generator elements array, a plurality of thermal connection elements in contact with the rotor from one side and with the thermoelectric elements on the other side, having means to produce electricity during braking and transferring heat from the rotor to the brake body, and with the additional features to have a sensor to provide electrical power by converting the temperature of the rotor, control media to communicate with the temperature sensor with further switching capability to different operating modes. Apart for the strong limitations intrinsic on the requirements by the disclosed invention, as for the afore analyzed cases still the reliability issues and manufacturability are not event tackled. In fact, for instance, the pressure coming from the reaction of the rotor over the pad will be propagated from the thermal connection elements directly down to the thermoelectric elements potentially in a disrupting way because of the pressure levels experienced by the brake pads.

The object of the present invention is to provide a brake pad with integrated thermoelectric energy harvester for any braking system, which overcoming the limitations suffered by known thermoelectric applications in brakes.

Another object of the present invention is to provide a braking pad with integrated thermoelectric energy harvester for any braking system having an improved temperature difference available to the thermoelectric module.

Another object of the present invention is to provide a braking pad with thermoelectric energy harvester for any braking system having a reduced impact to the braking device for the thermoelectric module integration to eliminate any issue related to changes on the NVH behavior or changes in the braking device performances, or even worse the friction detachment resilience to shear forces.

Another object of the present invention is to provide a braking pad with thermoelectric energy harvester for any braking system having an improved long term reliability and pressure load resistance.

The objects of the present invention are achieved by a braking pad -comprising a back plate, a pad of friction material, and at least a thermoelectric module comprising P and N type semiconductor elements, characterized in that said backplate is provided with at least a through hole wherein at least said P and N type semiconductor elements of said thermoelectric module are integrated.

In an embodiment of the invention said thermoelectric module is entirely integrated in said hole. Advantageously a first and a second heat exchangers are positioned in contact to opposite surfaces of said thermoelectric module.

Advantageously said through-hole has a first end opening on an internal main surface of said back plate and a second end opening on an external main surface of said back plate parallel to said internal main surface.

Preferably said through hole is one of the spigot-hole present on a typical Brake pad backplate of known type suitably processed to integrate said thermoelectric module.

In a preferred embodiment of the invention said thermoelectric module is in form of a plate having a first main surface facing to said internal main surface of said back plate and a second main surface facing to said external main surface of said back plate.

In a preferred embodiment of the invention said plate has said first main surface flat and parallel to said internal main surface of said back plate and said second main surface flat and parallel to said external main surface of said back plate.

In a preferred embodiment of the invention said first and second main surfaces of said thermoelectric module are located inside said through hole.

In a preferred embodiment of the invention said first heat exchanger is positioned in contact on said first main surface of said thermoelectric module and said second heat exchanger is positioned in contact on said second main surface of said thermoelectric module.

In an embodiment of the invention said first heat exchanger extends in a channel of said friction pad.

In an embodiment of the invention said first heat exchanger is fixed to the friction material wall of said channel of said friction pad.

In an embodiment of the invention said first heat exchanger is flush with an external main surface of said friction pad.

In an embodiment of the invention said first heat exchanger extends in a channel of an under layer interposed between said friction pad and said back plate.

In a preferred embodiment of the invention said second heat exchanger is flush with said second end of said through hole.

In an embodiment of the invention at least one of said first and second hat exchanges is made of graphite.

In a preferred embodiment of the invention said through hole comprises a cylindrical first end section including said first end of said through hole and having a first diameter, a cylindrical intermediate section having a second diameter larger than said first diameter, and a cylindrical second end section including said second end of said through hole and having a third diameter larger than said second diameter.

In a preferred embodiment of the invention said first and second heat exchanger have cylindrical shape.

In a preferred embodiment of the invention said first heat exchanger engages said cylindrical first end section of said through hole and said second heat exchanger engages said cylindrical second end section of said through hole.

In an embodiment of the invention said first heat exchanger has a narrowed cylindrical end portion engaging said back plate around said cylindrical first end section of said through hole.

In a preferred embodiment of the invention said thermoelectric module is housed in said cylindrical intermediate section of said through hole.

In an embodiment of the invention the back plate has a plurality of through holes and a plurality of interconnected thermoelectric modules, each thermoelectric module being integrated in a corresponding through hole.

The present invention also discloses a braking device comprising the above braking pad and an energy management unit connected to said thermoelectric module, said energy management unit comprising a control logic, a supply electric circuit to a load, and an energy accumulator connected to said supply electrical circuit.

In a preferred embodiment of the invention said supply electric circuit comprises a plurality of switches switching between a charge status and a discharge status, and said energy accumulator comprises a plurality of capacitors or Super-Capacitors, in said charge status said switches connecting in parallel said capacitors or Super-Capacitors and in said discharge status said switches connecting in series said capacitors (Super-Capacitors).

Further characteristics and advantages of the present invention will become clear from the following description of an exemplary non limiting embodiment given purely by way of example and with reference to the drawings attached, in which:
Fig. 1 shows a typical temperature profile in a braking pad after or during some braking applications;
Fig. 2 shows a scheme of a single thermoelectric module;
Fig. 3a shows a plan view of a back plate with spigot holes;
Fig. 3b shows a plan view of a detail of a back plate with a spigot hole processed to be adapted to integrate a thermoelectric module according to the present invention;
Fig. 4a shows an exploded view of the braking pad according to a first embodiment of the invention;
Fig. 4b shows a sectional view of an enlarged detail of the braking pad of the first embodiment;
Fig. 5 shows a perspective view of the braking pad of figure 4 wherefrom thermoelectric module and heat exchangers have been removed for a better understanding;
Fig. 6 is a plan view of the braking pad according to a second embodiment of the invention;
Fig. 7 shows a section of braking pad taken along lines A-A of figure 6;
Fig. 8 shows an enlarged detail of fig. 7;
Fig. 9 is a plan view of the braking pad according to a third embodiment of the present invention;
Fig. 10 shows a section of braking pad taken along lines A-A of figure 9;
Fig. 11 shows an enlarged detail of fig. 10;
Figs 12a and 12b show possible parallel and respectively series connection of thermoelectric modules of the present invention;
Fig. 13a shows the energy managing unit of a braking device including a braking pad according to the present invention;
Fig. 13b shows an embodiment of the energy accumulator of the energy managing unit of fig. 13a;
Figs. 14a and 14b show the supply circuit in the charging status and respectively discharging status;
Figs 15a and 15b show schemes of braking pad of a first and respectively a second prototype used for testing;
Fig. 16 shows acquired data from the prototype A; and
Fig. 17 shows acquired data from the prototype A under load.

With reference to figures equivalent parts in different embodiments of the invention will be labelled with the same reference number.

The braking pad 1, for instance of a vehicle, comprises a back plate 2, a pad of friction material 4, and one or more thermoelectric modules 6 each comprising in a known manner N and P doped semiconductor elements.

The brake pad 1 is also equipped with an under layer 8 interposed between the friction pad 4 and the back plate 2.

The pad of friction material 4 is on an internal main surface 2a of the back plate 2.

The back plate 2 has the internal flat main surface 2a and an external flat main surface 2b parallel to the external flat main surface 4a.

The friction pad 4 has an external flat main surface 4a and an internal flat main surface 4b parallel to the external flat main surface 4a.

The under layer 8 has a first flat main surface 8a and a second flat main surface 8b parallel to the first flat main surface 8a.

The first flat main surface 8a of the under layer 8 mates with the internal flat main surface 4b of the friction pad 4 while the second flat main surface 8b of the under layer 8 mates with the internal flat main surface 2a of the back plate 2.

The back plate 2, usually in metal, is advantageously provided with one or more through holes 3 (commonly known as Spigot-Holes).

Advantageously each thermoelectric module 6 is entirely integrated in a corresponding through hole 3 of the back plate 2.

In a different embodiment of the invention not shown not the entire thermoelectric module 6 but at least N and P doped semiconductor elements of the thermoelectric module 6 are integrated on the hole 3.

Each through hole 3 has a first end 3a opening on the internal main surface 2a of the back plate 2 and a second end 3b opening on an external main surface 2b of the back plate 2.

Preferably each through hole 3 is a spigot hole of a known type commonly present in a back plate 2 and suitably adapted to integrate the thermoelectric module 6.

In further detail each through hole 3 comprises a cylindrical first end section 3' including said first end 3a of said through hole 3 and having a first diameter D1, a cylindrical intermediate section 3" having a second diameter D2 larger than the first diameter D1, and a cylindrical second end section 3''' including the second end 3b of the through hole 3 and having a third diameter D3 larger than the second diameter D2.

The thermoelectric module 6 is in form of a plate having a first main surface 6a facing to the internal main surface 2a of the back plate 2 and a second main surface 6b facing to the external main surface 2b of the back plate 2.

More specifically the first main surface 6a of the thermoelectric module 6 is parallel to the internal main surface 2a of the back plate 2 and the second main surface 2b of the thermoelectric module 6 is parallel to the external main surface 2b of the back plate 2.

More precisely the first main surface 6a of the thermoelectric module 6 and second main surface 6b of thermoelectric module 6 are located inside the through hole 3.

A first heat exchanger 5 is positioned in contact on the first main surface 6a of the thermoelectric module 6 and a second heat exchanger 7 is positioned in contact on the second main surface 6b of the thermoelectric module 6.

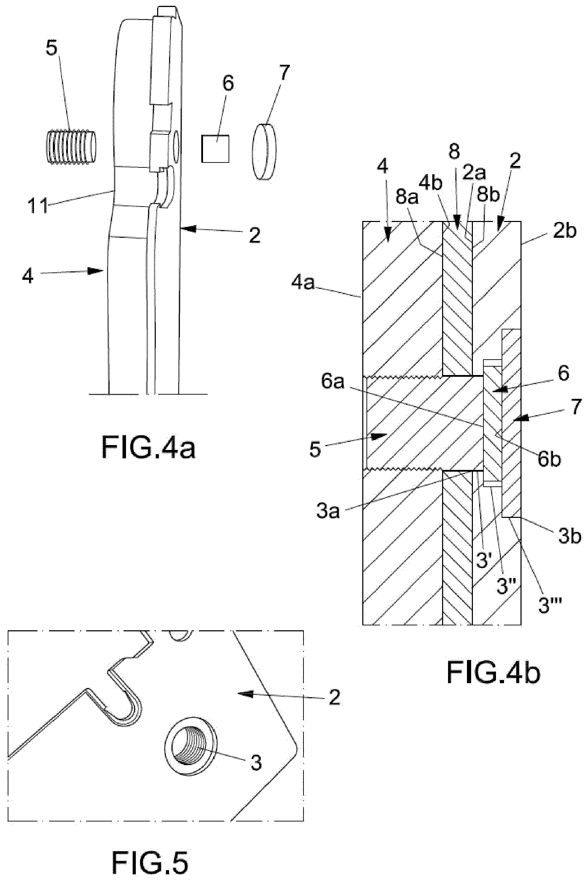

The first heat exchanger 5 extends in a channel 9 of the under layer 8 and may further extend in a channel 10 of the friction pad 4 as shown in embodiments of figures 4 to 8.

Channel 9 develops through the entire thickness of the under layer 8 so connecting the friction pad 4 to the back plate 2.

Channel 10, if foreseen, may develop through at least one portion and preferably the entire thickness of the friction pad 4.

Preferably, when channel 10 develops through the entire thickness of the friction pad 4, the first heat exchanger 5 is flush with the main outer surface 4a of the friction pad 4.

The second heat exchanger 7 has one end flush with the second end 3b of the through hole 3.

The first heat exchanger 5 and the second heat exchanger 7 have cylindrical shape.

The first heat exchanger 5 engages the cylindrical first end section 3' of the through hole 3 and the second heat exchanger 7 engages the cylindrical second end section 3''' of the through hole 3.

Preferably the second heat exchanger 7 is in form of a plate conjugated in shape with the cylindrical second end section 3''' of the through hole 3.

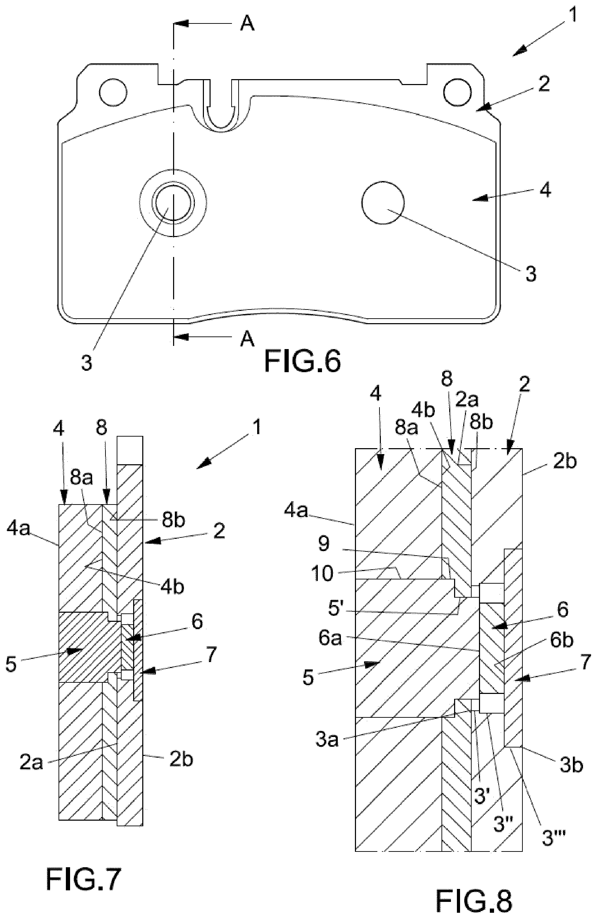

In embodiments shown in figures 6 to 11 the first heat exchanger 5 has an narrowed cylindrical end portion 5' engaging the back plate 2 around the cylindrical first end section 3' of the through hole 3. The thermoelectric module 6 is housed in the cylindrical intermediate section 3" of the through hole 3.

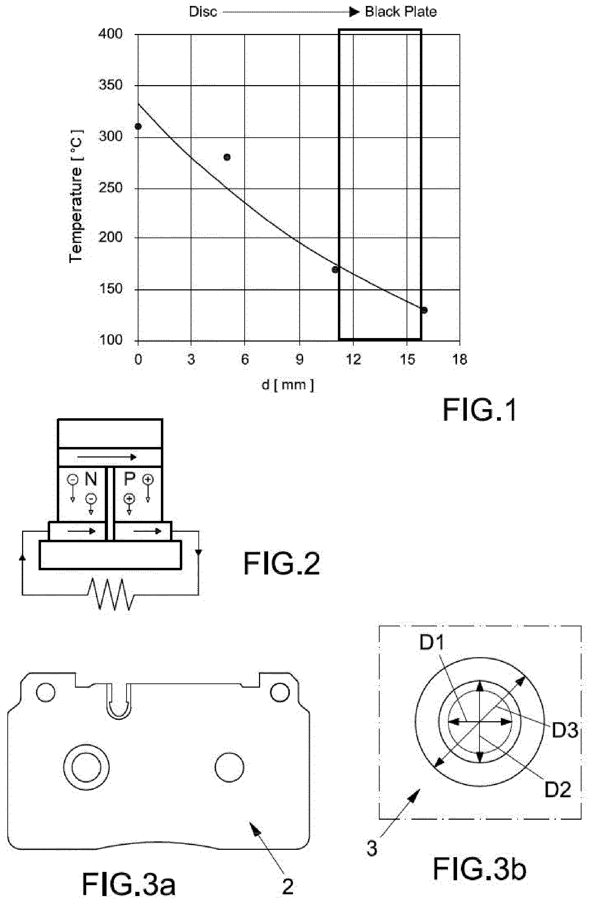

To substantiate the reason for the proposed solution let us go back to the typical temperature profile in a brake pad after or during some braking applications as shown in fig. 1.

In fig. 1 is shown the thermal profile of the braking pad from the rotor surface (warm side) down to the back plate (cold side).

It is seen that the last two measured points (by placing thermal probes into the friction material, rotor, and back plate) are relate to the two sides of the back plate on the friction material side and the opposite.

It can be appreciated 50 °C over 200 °C (25%) are lost between the two sides of the back plate. That means that over 25% of the efficiency can be recovered by a careful design in positioning the cold side heat exchanger.

The invention preferably exploits so called spigot holes normally present in a back plate of a braking pad and playing a role during the pressing of the friction material in the manufacturing process.

Spigot holes are ideal for thermoelectric module integration into the braking pad, since: they do not offer any contribution to the adhesion between friction material and back plate; they put in connection naturally the inner side of the back plate with its external part so offering an ideal assist to maximize the temperature gradient; and they do not imply any mechanical or structural modification of the braking pad to contact interior and external side of the braking pad, so minimizing pernicious impact on the NVH side or performance side due to these kind of mechanical modifications.

Let us now refer first to embodiment shown in figures 4 and 5.

The through spigot hole on the back plate 2 is worked to integrate the thermoelectric module 6 and heat exchanger 5, 7. To this purpose a first recess deep about 2 to 3 mm is milled to create the cylindrical second end section 3''' of the through hole 3, then a second recess from the bottom of the first recess is milled to create the cylindrical intermediate section 3" of the through hole 3 separating the cylindrical first and second end sections 3', 3''' of the through hole 3.

Also channel 9 is created through the under layer 8 and threaded channel 10 is created through friction pad 4.

In this case also the first heat exchanger 5 on the warm side is made of metal and is threaded to screw engage permanently with the threaded channel 10 of the friction pad 4.

The first heat exchanger 5 is simply screwed into the friction material that being hard enough makes also the mechanical function to support the first heat exchanger itself 5 to provide a substantial pressure release over the surface of the underlying thermoelectric module 6. However other methods can be thought in principle for attaching and sealing the two elements, like gluing it to the friction pad with some structural high temperature resin of the siliconic, bismalleimide, epoxidic, ester cyanides or polyimide families to fill any gap between the first heat exchanger 5 and the friction material and seal it for the water absorption.

The end face of the first heat exchanger 5 must be flat to fit with the corresponding flat face of the thermoelectric module 6. As said the thermoelectric module 6 is composed by at least two opposite p-n junctions (with respect the hot and cold side) set in parallel the two termination or the thermoelectric module are closed by two high temperature cable or by screen printing circuit that brings outside of the module the generated current.

One main surface 6a of the module 6 is in direct contact with the corresponding flat face of the first heat exchanger 5 and a thin layer of high temperature thermal conductive paste can be used to improve the thermal contact between parts 5 and 6. The other main surface 6b of the module 6 is in touch with the corresponding flat face of the second heat exchanger 7, which is coin-shaped.

Even in this case high temperature thermal conductive glue can be used to improve the thermal contact between parts 6 and 7 (preferably with maximum operative T > 200 °C). The coin-shaped cold side heat exchanger 7 being flat and made of materials with high thermal conductivity keeps the cold side of the module 6 practically speaking at the same temperature of the external side of the back plate 2 or lower due to the higher thermal conductivity of such material (Aluminum or copper) with respect the steel adopted for standard braking pads.

Concerning the first heat exchanger 5, other technical solutions can be used instead of a threaded hole to relief the pressure over the module 6. One will be shown in the next embodiment involving a different shaping of the warm side heat exchanger 5 and a careful design of the quotes to avoid large pressure over such module 6.

The mounting scheme of the module 6 in this first embodiment is as follows.

The screwed metallic pin (the first heat exchanger 5 on the hot side) is positioned into the cylindrical first end section 3' of the through hole 3. High temperature glues or sealant are placed into the hole 3 to seal the space between the cylindrical first end section 3' of the through hole 3 and the screwed metallic pin.

A thermal paste is positioned upon the metallic flat face of the first heat exchanger 5 and the thermoelectric element 6 is placed upon it in the cylindrical intermediate section 3" of the through hole 3. Cables or interconnecting elements are put outside of the back plate 2 on the surface of the back plate 2 or in the middle of it through some aperture to let the wire to pass through.

A thermal paste or sealing thermal glue is placed on top of the thermoelectric element 6 and the metallic coin element (the second heat exchanger 7 on the cold side) in placed on it. The second heat exchanger 7 closes completely the hole 3 resulting in a metallic element which is in-built with the back plate 2 and perfectly aligned with its surface to avoid formation of unwanted drag into the caliper.

Once assembled the brake pad 1 is ready to be used on a caliper, and by interconnecting the two terminal (by the two cables integrated on the braking pad 1) a load can be fed by the thermoelectric module 6 in the braking pad 1 as long as a thermal gradient will be present on the braking pad 1.

The present first embodiment has a clear limit due to its metallic heat exchanger 5 that can be used only with coated brake disk, where wear issues are not relevant. In these special cases the heat exchanger is preferably made of high thermal conduction and cheap metals (Aluminum and Copper), but in principles also other insulating materials with high thermal conduction like some ceramics (Alumina and others) can be used.

Let us focus now on second embodiment shown in figures 6 to 8.

As we said in the last paragraph a metallic first heat exchanger can be used in limited cases, like coated brake disks, where the scraping action of the metal insertion into the pad on a disk surface is not an issue owing to the very hard coating material of the disks and very limited wear of the pad. In all the other cases it will not be usable for the same reason because the disk will be quickly irremediably damaged.

In all these cases a soft material with high thermal conductivity must be used to avoid disk surface damages. A material with such characteristics is the graphite. Graphite has in fact a thermal conductivity comparable to those of many metals (usually comprised between 50-400 W/mK) and in some cases larger than that of aluminum (λ ∼ 180 W/mK).

The large spread of values is due to the fact that in-plane conductivity is much larger than intraplanar conductivity (two orders smaller). As a result the actual value will be influenced by the purity level and most important the grain orientation of the microstructure of the graphite materials which compose a typical Graphite rod, depending on the fraction of the grains oriented along the cylinder axis of the rod with the graphite plane on that direction. The favorite choice is for graphite compounds with conductivity larger than 100 W/mK, and preferably larger than 200 W/mK, i.e. better that the metallic case.

Compared to the first embodiment in the second embodiment the main difference is that at least the first heat exchanger 5 is made of graphite. This graphite first heat exchanger 5 is modeled in a similar way than the metallic version, with one flat face aligned with the corresponding one of the friction material pad 4 and the other flat face hosting a corresponding flat face of the module 6.

However another important difference with respect to the previous screwed solution is displayed to release pressure on the module 6: to release pressure on module 6 the first heat exchanger 5 has now the narrowed cylindrical end portion 5' engaging the back plate 2 around the cylindrical first end section 3' of the through hole 3. This way any potential impact on the braking pad specifications is minimized. Thermoelectric module 6 is integrated on the back plate 2 in a similar way as done for the previously discussed metal case. The second heat exchanger 7 on the cold side can be done indifferently with graphite or metal provided as a thin coin of high thermal conductivity material.

Thanks to the properties of the graphite material, the graphite first heat exchanger 5 will not interfere with the braking action of the braking pad 1 and most important will not scrap the rotor surface, being the lubricant nature of graphite, which is also used in the braking pads friction materials to balance different physical properties of the pad. Besides of that the graphite first heat exchanger will wear following the friction material resulting in an always flat and aligned surface in contact with the rotor, ensuring a good thermal contact with the time and pad wear process.

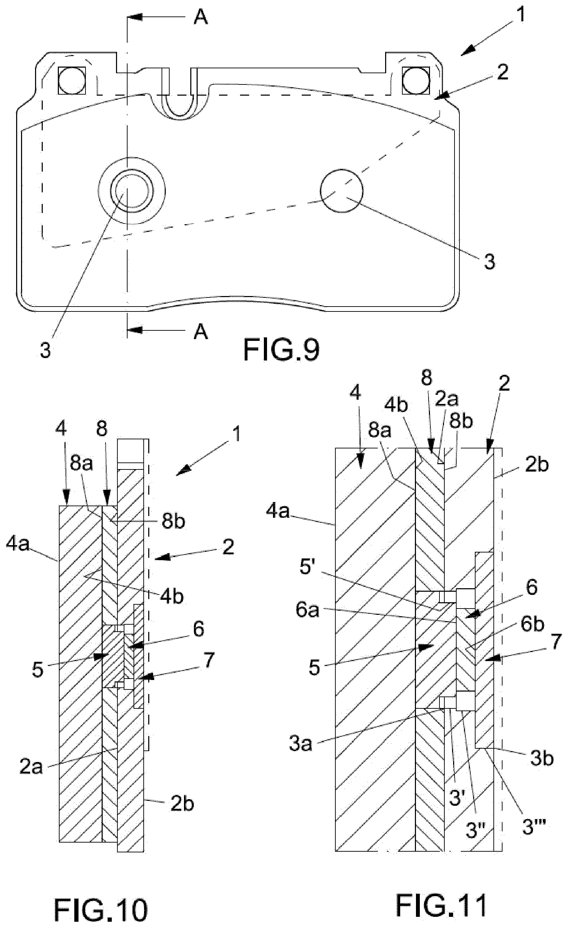

Let now discuss the third embodiment shown in figures 9 to 11.

The third embodiment is the one with a short first heat exchanger 5 on the warm side. In particular, instead of extending up to the level of the extreme side of the friction material to be directly in contact with the brake rotor, it will be limited to the edge of the under layer 8.

This latter configuration in spite less efficient, because of the smaller thermal gradient exposed by the two sides of the module 6, will have a manufacturability advantage with respect to the previous two, a much less invasive integration of the module 6 and, last but not least, a lower cost due to the smaller quantities of materials employed. This is the favorite embodiment for all the applications where the produced energy is not the main issue, (low power budget applications) and therefore it includes all the wireless sensors application in friction brakes or friction based applications (Brake Drums, Clutches etc.).

The two heat exchangers 5, 7 in this specific case can be made of metal or graphite indifferently since the two heat exchangers 5, 7 will be beneath the friction material of the brake pad 4 and below the level of the under layer 8. The favorite design will be that with the edge of the first heat exchanger 5 substantially in line with the limit of the under layer 8 to optimize the thermal gradient. Therefore the material employed for the heat exchangers 5, 7 will be driven by cost and efficiencies issues than others.

All the embodiments showed before have a natural extension to a case where a multiple similar structures can be realized. This can be done for example by simply exploiting all the present spigot holes in the brake pad, which normally are 2 or 3 in a standard braking pad.

Of course also one or more holes 3 may be made into the back plate 2 in addition to those deriving from already existing spigot holes to host more modules 6 into the braking pad 1, by keeping the same design of the adapted spigot holes.

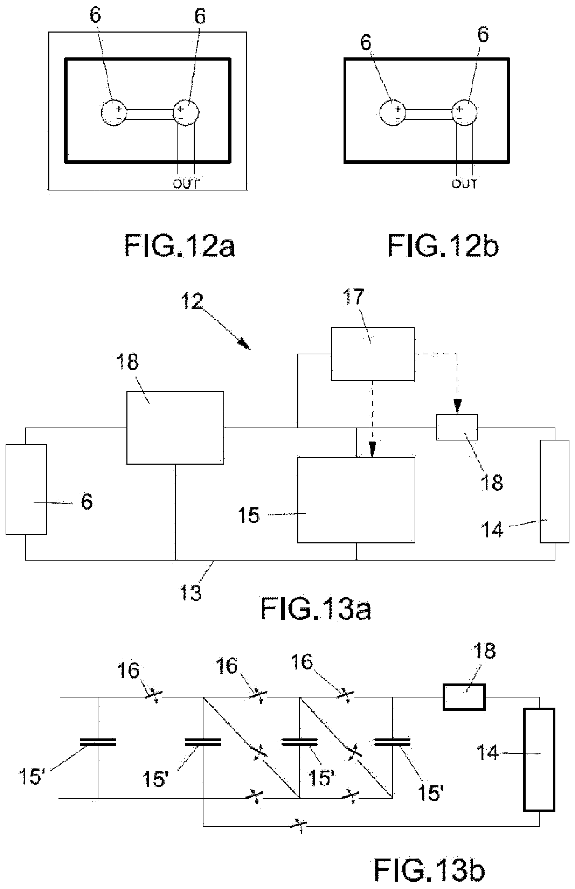

The multiple modules 6 can be then interconnected to allow series or parallel interconnections depending if the voltage outputs or the electrical currents need to be maximized, or both (see figures 12a and 12b).

Advantageously an energy management unit 12 is connected to the thermoelectric module 6.

The energy management unit 12 comprises control logic 17, a supply electric circuit 13 to a load 14, and an energy accumulator 15 connected to the supply electrical circuit 13.

The supply electric circuit 13 comprises a plurality of switches 16 switching between a charge status and a discharge status.

The energy accumulator 15 comprises a plurality of capacitors 15.

In the charge status the switches 16 connect in parallel the capacitors 15' and in the discharge status they connect in series the capacitors 15'.

The energy management unit maximizes the energy recovered and supplies the entire extra power budget to feed the specific application powered with this unit.

This is extremely important in particular with a case like a braking system where brake application in general cannot be too frequent and in any case are intrinsically aleatory. Therefore, the usability of a thermoelectric module integrated into the pad can profit a lot from the integration with an electronic system.

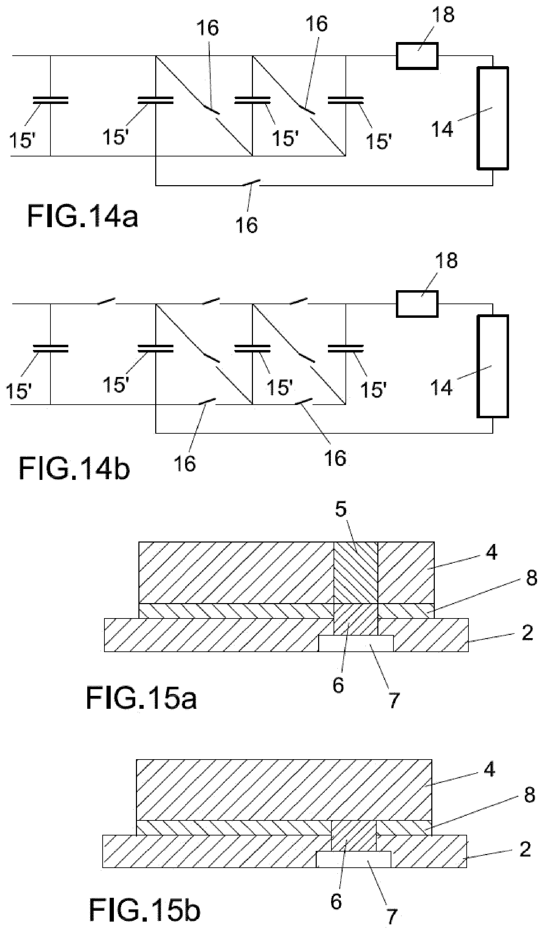

With reference to figures 13a, 13b, 14a, 14b the output from the module 6 is managed by a voltage regulator 18 to get always the same voltage to load the energy accumulator 15.

The ultra-low power control logic 17 handles the switches 16 from the charge status of the super capacitors 15' to the discharge status when the load 14 conditions require high quantities of current. The control logic 17 operates for instance on a diode 18 as a smart switch opening the branch of the circuit 13 closed to the external load 14.

In figure 14a, corresponding to the charging status, all the switches 16 are closed but the ones on the diagonal. This means that all the super capacitors 15' are on charging fed by the module 6 and they will charge at the same voltage of the voltage regulator 18. This condition will happen whenever no load is present or it doesn't require any current from the module 6.

In figure 14b, corresponding to the discharging status, the control logic 17 opens all the switches 16, with the exception of those on the diagonal. As a consequence the first super capacitor 15' is sectioned from the rest of the circuit and it is still fed by the module 6 to keep charging during this phase and avoid the majority of charge losses. The remaining super capacitors 15' are in series and can fed an external circuit with higher voltage. This latter aspect is interesting because it can provide an advantage allowing to use simplified module 6 with lower operating voltage (so cheaper) and reachable even in mild operating condition (small thermal gradients), while in discharging status it can power standard electronic systems without any special requirements concerning the components to be used with advantages in costs and compatibility with automotive standards.

With reference to figures 15a, 15b, 16 and 17 we will show the result of testing sessions on two different energy harvesting prototype: prototype A shown in figure 15a and complying with the second embodiment discussed above, wherein the first heat exchanger 5 is made of graphite and the second heat exchanger 7 is made of aluminum; and prototype B shown in fig. 15b wherein, compared to prototype A, the first heat exchanger is missing.

Both graphite (λ ∼ 50-400 W/mK) and aluminum (λ ∼ 180 W/mK) are good thermal conductors that let us to maximize the thermal transport through the pad. Concerning prototype A, the presence of graphite pinole 5 on the friction material surface doesn't produce damages on the disc due the graphite tendency to exfoliate itself.

The test consists in brake applications at mild pressure (up to 10 bars) with the aim to establish a thermal gradient between friction material side and the back plate one.

The disc temperature, assumed equal to friction material temperature (hot side), was acquired with a pyrometer and the back plate temperature (cold side) was acquired with a K-type thermocouple.

Furthermore we acquired the pad voltage in order to estimate the efficiency of the system in terms of power end energy generated during the brake application.

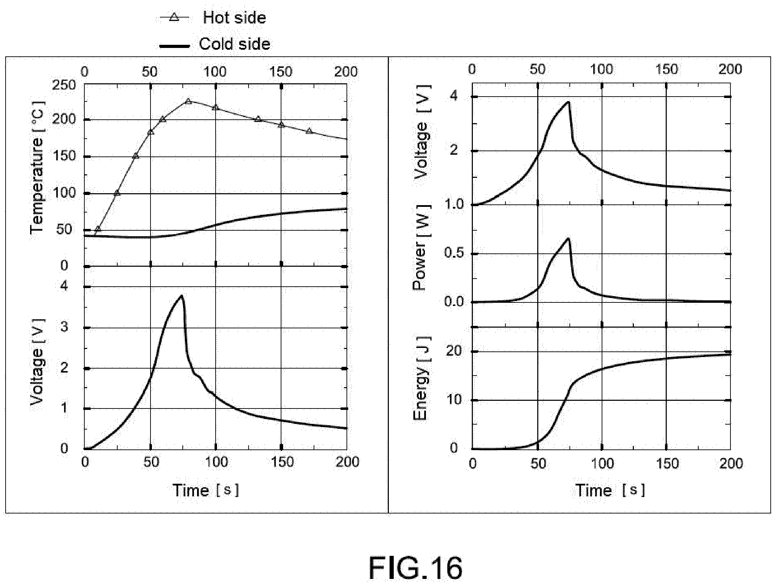

Prototype A is the most efficient of tested prototypes in terms of power generation. As showed in figure 16 for a maximum thermal gradient of 170°C the module gives a maximum voltage of 3.8V. When the disc temperature exceeds the set point (∼200°C) the system is cooled down and let us to see the cooling dynamics of the module. After the pressure off it is possible estimate the loss of voltage during the time. In the first 50 seconds the voltage loss over time is dV/dt ∼ 50 mV/s after the transient the system thermalized and dV/dt became approximately zero with a voltage output of 500 mV.

The figure 16 at right side shows the comparison between voltage, power and energy generated during the brake application. The power reaches the peak value 700 mW and the energy generated during the brake application is near 20 J.

The module operates as voltage generator and in order to estimate the total power generated during the brake application we have applied a load between the two poles of the generator.

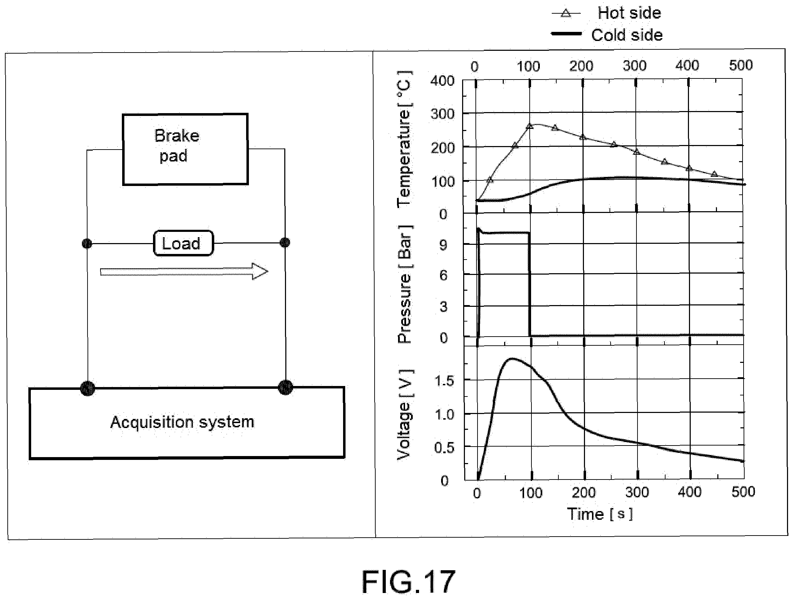

When performing the same test with the presence of a resistive load as shown in figure 17 it is observed a decreasing of the output voltage from 3.5 to 1.8 V. The smaller voltage level reached is associated with an internal power losses with respect the open circuit condition without load. The power will drop correspondently for a single module, it is anyhow a remarkable power for such a small unit (<1 cm²)

Prototype B is less efficient than prototype A but the test put in evidence pretty good performance as well. The advantage of the prototype B is that the thermoelectric module is embedded inside the under layer that plays a protective role.

Both the system once coupled to an energy management system can feed electronic systems for a time that will be determined by the amount of energy harvested.

## Claims

1. A braking pad (1), comprising a back plate (2), a pad of friction material (4), and at least a thermoelectric module (6) comprising P and N type semiconductor elements, said thermoelectric module (6) having a first main surface (6a) and a second main surface (6b) opposite to said first main surface (6a), a first heat exchanger (5) being provided in contact to said first main surface (6a) of said thermoelectric module (6), **characterized in that** said back plate (2) is provided with at least a through hole (3) wherein at least said N and P doped semiconductor elements of said thermoelectric module (6) are integrated, and **in that** a second heat exchanger (7) housed in said through hole (3) is provided in contact to said second main surface (6b) of said thermoelectric module (6).

2. A braking pad (1) according to claim 1, **characterized in that** said first heat exchanger (5) is fixed to a channel (10) of said friction pad (4).

3. A braking pad (1) according to any previous claim, **characterized in that** said thermoelectric module is entirely integrated in said hole.

4. A braking pad (1) according to any previous claims, **characterized in that** said through hole (3) has a first end (3a) opening on an internal main surface (2a) of said back plate (2) and a second end (3b) opening on an external main surface (2b) of said back plate (2) parallel to said internal main surface (2a).

5. A braking pad (1) of a vehicle according to any previous claim, **characterized in that** said through hole (3) is a spigot hole usually present on a back plate of known type, said spigot hole being processed to integrate said thermoelectric module (6).

6. A braking pad (1) according to any claim 4 and 5, **characterized in that** said thermoelectric module (6) is in form of a plate having said first main surface (6a) facing to said internal main surface (2a) of said back plate (2) and said second main surface (6b) facing to said external main surface (2b) of said back plate (2).

7. A braking pad (1) according to claim 6, **characterized in that** said plate has said first main surface (6a) flat and parallel to said internal main surface (2a) of said back plate (2) and said second main surface (6b) flat and parallel to said external main surface (2b) of said back plate (2).

8. A braking pad (1) according to any claim 6 and 7, **characterized in that** said first and second main surfaces (6a, 6b) of said thermoelectric module (6) are located inside said through hole (3).

9. A braking pad (1) according to any claim 6 to 8, **characterized in that** said first heat exchanger (5) is positioned in contact on said first main surface (6a) of said thermoelectric module (6) and said second heat exchanger (7) is positioned in contact on said second main surface (6b) of said thermoelectric module (6).

10. A braking pad (1) according to the previous claim, **characterized in that** said second heat exchanger (7) is flush with said second end (3b) of said through hole (3).

11. A braking pad (1) according to any claim 9 and 10, **characterized in that** said first heat exchanger (5) extends outside said first end (3a) of said through hole (3).

12. A braking pad (1) according to the any previous claim, **characterized in that** said first heat exchanger (5) is flush with an external main surface (4a) of said friction pad (4).

13. A braking pad (1) according to any previous claim, **characterized in that** said first heat exchanger (5) extends in a channel (9) of an under layer (8) interposed between said friction pad (4) and said back plate (2).

14. A braking pad (1) according to any previous claim, **characterized in that** at least one of said first and second heat exchangers (5, 7) is made by a material that has thermal conductivity higher than 50 W/mK.

15. A braking pad (1) according to previous claim , **characterized in that** at least one of said first and second heat exchangers (5, 7) is made by a graphite.

16. A braking pad (1) according to any previous claim, **characterized in that** said through hole (3) comprises a cylindrical first end section (3') including said first end (3a) of said through hole (3) and having a first diameter (D1), a cylindrical intermediate section (3") having a second diameter (D2) larger than said first diameter (D1), and a cylindrical second end section (3''') including said second end (3b) of said through hole (3) and having a third diameter (D3) larger than said second diameter (D2).

17. A braking pad (1) according to any previous claim, **characterized in that** said first and second heat exchangers (5, 7) have cylindrical shape.

18. A braking pad (1) according to claim 17, **characterized in that** said first heat exchanger (5) engages said cylindrical first end section (3') of said through hole (3) and said second heat exchanger (7) engages said cylindrical second end section (3''') of said through hole (3).

19. A braking pad according to claim 18, **characterized in that** said first heat exchanger (5) has an narrowed cylindrical end portion (5') engaging said back plate (2) around said cylindrical first end section (3') of said through hole (3).

20. A braking pad according to any claim 18 and 19, **characterized in that** said thermoelectric module (6) is housed in said cylindrical intermediate section (3") of said through hole (3).

21. A braking device comprising a braking pad (1) according to any previous claim and an energy management unit (12) connected to said thermoelectric module (6), said energy management unit (12) comprising a logic control (17), a supply electric circuit (13) to a load (14), and an energy accumulator (15) connected to said supply electrical circuit (13), said supply electric circuit (13) comprising a plurality of switches (16) switching between a charge status and a discharge status, and said energy accumulator (15) comprises a plurality of capacitors (15'), and in that in said charge status said switches (16) connect in parallel said capacitors (15') and in said discharge status said switches (16) connect in series said capacitors (15').

## Patentansprüche

1. Bremsbelag (1), umfassend eine Rückplatte (2), einen Reibmaterialbelag (4) und mindestens ein thermoelektrisches Modul (6), das P- und N-Halbleiterelemente umfasst, wobei das thermoelektrische Modul (6) eine erste Hauptfläche (6a) und eine zweite Hauptfläche (6b) gegenüber der ersten Hauptfläche (6a) und einen ersten Wärmetauscher (5) aufweist, der in Kontakt mit der ersten Hauptfläche (6a) des thermoelektrischen Moduls (6) vorgesehen ist, **dadurch gekennzeichnet, dass** die Rückplatte (2) mit mindestens einem Durchgangsloch (3) versehen ist, wobei mindestens die N- und P-dotierten Halbleiterelemente des thermoelektrischen Moduls (6) integriert sind, und dass ein zweiter Wärmetauscher (7), der in dem Durchgangsloch (3) aufgenommen ist, in Kontakt mit der zweiten Hauptfläche (6b) des thermoelektrischen Moduls (6) vorgesehen ist.

2. Bremsbelag (1) nach Anspruch 1, **dadurch gekennzeichnet, dass** der erste Wärmetauscher (5) an einem Kanal (10) des Reibbelags (4) befestigt ist.

3. Bremsbelag (1) nach einem der vorstehenden Ansprüche, **dadurch gekennzeichnet, dass** das thermoelektrische Modul vollständig in das Loch integriert ist.

4. Bremsbelag (1) nach einem der vorstehenden Ansprüche, **dadurch gekennzeichnet, dass** das Durchgangsloch (3) ein erstes Ende (3a), das sich an einer inneren Hauptfläche (2a) der Rückplatte (2) öffnet, und ein zweites Ende (3b) aufweist, das sich an einer äußeren Hauptfläche (2b) der Rückplatte (2) parallel zu der inneren Hauptfläche (2a) öffnet.

5. Bremsbelag (1) eines Fahrzeugs nach einem der vorstehenden Ansprüche, **dadurch gekennzeichnet, dass** das Durchgangsloch (3) ein Zapfenloch ist, das gewöhnlich an einer Rückplatte einer bekannten Art vorhanden ist, wobei das Zapfenloch derart verarbeitet ist, dass das thermoelektrische Modul (6) integriert ist.

6. Bremsbelag (1) nach einem der Ansprüche 4 und 5, **dadurch gekennzeichnet, dass** das thermoelektrische Modul (6) die Form einer Platte aufweist, welche die erste Hauptfläche (6a), die der inneren Hauptfläche (2a) der Rückplatte (2) zugewandt ist, und die zweite Hauptfläche (6b) aufweist, die der äußeren Hauptfläche (2b) der Rückplatte (2) zugewandt ist.

7. Bremsbelag (1) nach Anspruch 6, **dadurch gekennzeichnet, dass** die Platte die erste Hauptfläche (6a) flach und parallel zu der inneren Hauptfläche (2a) der Rückplatte (2) und die zweite Hauptfläche (6b) flach und parallel zu der äußeren Hauptfläche (2b) der Rückplatte (2) aufweist.

8. Bremsbelag (1) nach einem der Ansprüche 6 und 7, **dadurch gekennzeichnet, dass** die erste und die zweite Hauptfläche (6a, 6b) des thermoelektrischen Moduls (6) innerhalb des Durchgangslochs (3) angeordnet sind.

9. Bremsbelag (1) nach einem der Ansprüche 6 bis 8, **dadurch gekennzeichnet, dass** der erste Wärmetauscher (5) in Kontakt auf der ersten Hauptfläche (6a) des thermoelektrischen Moduls (6) positioniert ist und der zweite Wärmetauscher (7) in Kontakt auf der zweiten Hauptfläche (6b) des thermoelektrischen Moduls (6) positioniert ist.

10. Bremsbelag (1) nach vorstehendem Anspruch, **dadurch gekennzeichnet, dass** der zweite Wärmetauscher (7) mit dem zweiten Ende (3b) des Durchgangslochs (3) bündig ist.

11. Bremsbelag (1) nach einem der Ansprüche 9 und 10, **dadurch gekennzeichnet, dass** sich der erste Wärmetauscher (5) außerhalb des ersten Endes (3a) des Durchgangslochs (3) erstreckt.

12. Bremsbelag (1) nach einem der vorstehenden Ansprüche, **dadurch gekennzeichnet, dass** der erste Wärmetauscher (5) mit einer äußeren Hauptfläche (4a) des Reibbelags (4) bündig ist.

13. Bremsbelag (1) nach einem der vorstehenden Ansprüche, **dadurch gekennzeichnet, dass** sich der erste Wärmetauscher (5) in einem Kanal (9) einer Unterschicht (8) erstreckt, die zwischen dem Reibbelag (4) und der Rückplatte (2) angeordnet ist.

14. Bremsbelag (1) nach einem der vorstehenden Ansprüche, **dadurch gekennzeichnet, dass** mindestens einer von dem ersten und dem zweiten Wärmetauscher (5, 7) aus einem Material hergestellt ist, das eine Wärmeleitfähigkeit von höher als 50 W/mK aufweist.

15. Bremsbelag (1) nach vorstehendem Anspruch, **dadurch gekennzeichnet, dass** mindestens einer von dem ersten und dem zweiten Wärmetauscher (5, 7) aus einem Graphit hergestellt ist.

16. Bremsbelag (1) nach einem der vorstehenden Ansprüche, **dadurch gekennzeichnet, dass** das Durchgangsloch (3) einen zylindrischen ersten Endabschnitt (3'), der das erste Ende (3a) des Durchgangslochs (3) umfasst und einen ersten Durchmesser (D1) aufweist, einen zylindrischen Zwischenabschnitt (3") mit einem zweiten Durchmesser (D2), der größer ist als der erste Durchmesser (D1), und einen zylindrischen zweiten Endabschnitt (3''') umfasst, der das zweite Ende (3b) des Durchgangslochs (3) umfasst und einen dritten Durchmesser (D3) aufweist, der größer ist als der zweite Durchmesser (D2).

17. Bremsbelag (1) nach einem der vorstehenden Ansprüche, **dadurch gekennzeichnet, dass** der erste und der zweite Wärmetauscher (5, 7) eine zylindrische Form aufweisen.

18. Bremsbelag (1) nach Anspruch 17, **dadurch gekennzeichnet, dass** der erste Wärmetauscher (5) mit dem zylindrischen ersten Endabschnitt (3') des Durchgangslochs (3) in Eingriff ist und der zweite Wärmetauscher (7) mit dem zylindrischen zweiten Endabschnitt (3''') des Durchgangslochs (3) in Eingriff ist.

19. Bremsbelag nach Anspruch 18, **dadurch gekennzeichnet, dass** der erste Wärmetauscher (5) einen verengten zylindrischen Endabschnitt (5') aufweist, der mit der Rückplatte (2) um den zylindrischen ersten Endabschnitt (3') des Durchgangslochs (3) herum in Eingriff ist.

20. Bremsbelag nach einem der Ansprüche 18 und 19, **dadurch gekennzeichnet, dass** das thermoelektrische Modul (6) in dem zylindrischen Zwischenabschnitt (3") des Durchgangslochs (3) aufgenommen ist.

21. Bremsvorrichtung, die einen Bremsbelag (1) nach einem der vorstehenden Ansprüche und eine Energiemanagementeinheit (12) umfasst, die mit dem thermoelektrischen Modul (6) verbunden ist, wobei die Energiemanagementeinheit (12) eine Logiksteuerung (17), eine elektrische Versorgungsschaltung (13) zu einer Last (14) und einen Energieakkumulator (15) umfasst, der mit der elektrischen Versorgungsschaltung (13) verbunden ist, und die elektrische Versorgungsschaltung (13) mehrere Schalter (16) umfasst, die zwischen einem Ladestatus und einem Entladestatus umschalten, und der Energieakkumulator (15) mehrere Kondensatoren (15') umfasst, und wobei in dem Ladezustand die Schalter (16) die Kondensatoren (15') parallel verbinden und in dem Entladezustand die Schalter (16) die Kondensatoren (15') in Reihe verbinden.

## Revendications

1. Plaquette de frein (1), comprenant une plaque arrière (2), un patin de matériau de friction (4), et au moins un module thermoélectrique (6) comprenant des éléments semi-conducteurs de type P et N, ledit module thermoélectrique (6) ayant une première surface principale (6a) et une deuxième surface principale (6b) opposée à ladite première surface principale (6a), un premier échangeur de chaleur (5) étant fourni en contact avec ladite première surface principale (6a) dudit module thermoélectrique (6), **caractérisée en ce que** ladite plaque arrière (2) est fournie avec au moins un trou traversant (3) dans lequel au moins lesdits éléments semi-conducteurs dopés N et P dudit module thermoélectrique (6) sont intégrés, et **en ce qu'**un deuxième échangeur de chaleur (7) logé dans ledit trou traversant (3) est fourni en contact avec ladite deuxième surface principale (6b) dudit module thermoélectrique (6).

2. Plaquette de frein (1) selon la revendication 1, **caractérisée en ce que** ledit premier échangeur de chaleur (5) est fixé à un canal (10) dudit patin de friction (4).

3. Plaquette de frein (1) selon l'une quelconque des revendications précédentes, **caractérisée en ce que** ledit module thermoélectrique est entièrement intégré dans ledit trou.

4. Plaquette de frein (1) selon l'une quelconque des revendications précédentes, **caractérisé en ce que** ledit trou traversant (3) a une première extrémité (3a) s'ouvrant sur une surface principale interne (2a) de ladite plaque arrière (2) et une deuxième extrémité (3b) s'ouvrant sur une surface principale externe (2b) de ladite plaque arrière (2) parallèle à ladite surface principale interne (2a).

5. Plaquette de frein (1) d'un véhicule selon l'une quelconque des revendications précédentes, **caractérisée en ce que** ledit trou traversant (3) est un trou rivet matière généralement présent sur une plaque arrière de type connu, ledit trou rivet traversant étant traité pour intégrer ledit module thermoélectrique (6).

6. Plaquette de frein (1) selon l'une quelconque des revendications 4 et 5, **caractérisée en ce que** ledit module thermoélectrique (6) est en forme d'une plaque ayant ladite première surface principale (6a) faisant face à ladite surface principale interne (2a) de ladite plaque arrière (2) et ladite deuxième surface principale (6b) faisant face à ladite surface principale externe (2b) de ladite plaque arrière (2).

7. Plaquette de frein (1) selon la revendication 6, **caractérisée en ce que** ladite plaque a ladite première surface principale (6a) plate et parallèle à ladite surface principale interne (2a) de ladite plaque arrière (2) et ladite deuxième surface principale (6b) plate et parallèle à ladite surface principale externe (2b) de ladite plaque arrière (2).

8. Plaquette de frein (1) selon l'une quelconque des revendications 6 et 7, **caractérisée en ce que** lesdites première et deuxième surfaces principales (6a, 6b) dudit module thermoélectrique (6) sont situées à l'intérieur dudit trou traversant (3).

9. Plaquette de frein (1) selon l'une quelconque des revendications 6 à 8, **caractérisée en ce que** ledit premier échangeur de chaleur (5) est positionné en contact sur ladite première surface principale (6a) dudit module thermoélectrique (6) et ledit deuxième échangeur de chaleur (7) est positionné en contact sur ladite deuxième surface principale (6b) dudit module thermoélectrique (6).

10. Plaquette de frein (1) selon la revendication précédente, **caractérisée en ce que** ledit deuxième échangeur de chaleur (7) affleure ladite deuxième extrémité (3b) dudit trou traversant (3).

11. Plaquette de frein (1) selon l'une quelconque des revendications 9 et 10, **caractérisée en ce que** ledit premier échangeur de chaleur (5) s'étend à l'extérieur de ladite première extrémité (3a) dudit trou traversant (3).

12. Plaquette de frein (1) selon l'une quelconque des revendications précédentes, **caractérisée en ce que** ledit premier échangeur de chaleur (5) affleure une surface principale externe (4a) dudit patin de friction (4).

13. Plaquette de frein (1) selon l'une quelconque des revendications précédentes, **caractérisée en ce que** ledit premier échangeur de chaleur (5) s'étend dans un canal (9) d'une sous-couche (8) interposée entre ladite plaquette de frein (4) et ladite plaque arrière (2).

14. Plaquette de frein (1) selon l'une quelconque des revendications précédentes, **caractérisée en ce qu'**au moins un desdits premier et deuxième échangeurs de chaleur (5, 7) est fabriqué en un matériau qui a une conductivité thermique supérieure à 50 W/mK.

15. Plaquette de frein (1) selon la revendication précédente, **caractérisée en ce qu'**au moins un desdits premier et deuxième échangeurs de chaleur (5, 7) est fabriqué en graphite.

16. Plaquette de frein (1) selon l'une quelconque des revendications précédentes, **caractérisée en ce que** ledit trou traversant (3) comprend une première section d'extrémité cylindrique (3') comprenant ladite première extrémité (3a) dudit trou traversant (3) et ayant un premier diamètre (D1), une section intermédiaire cylindrique (3") ayant un deuxième diamètre (D2) plus grand que ledit premier diamètre (D1), et une deuxième section d'extrémité cylindrique (3"') comprenant ladite deuxième extrémité (3b) dudit trou traversant (3) et ayant un troisième diamètre (D3) plus grand que ledit deuxième diamètre (D2).

17. Plaquette de frein (1) selon l'une quelconque des revendications précédentes, **caractérisée en ce que** lesdits premier et deuxième échangeurs de chaleur (5, 7) ont une forme cylindrique.

18. Plaquette de frein (1) selon la revendication 17, **caractérisée en ce que** ledit premier échangeur de chaleur (5) engage ladite première section d'extrémité cylindrique (3') dudit trou traversant (3) et ledit deuxième échangeur de chaleur (7) engage ladite deuxième section d'extrémité cylindrique (3"') dudit trou traversant (3).

19. Plaquette de frein selon la revendication 18, **caractérisée en ce que** ledit premier échangeur de chaleur (5) a une partie d'extrémité cylindrique rétrécie (5') engageant ladite plaque arrière (2) autour de ladite première section d'extrémité cylindrique (3') dudit trou traversant (3).

20. Plaquette de frein selon l'une quelconque des revendications 18 et 19, **caractérisé en ce que** ledit module thermoélectrique (6) est logé dans ladite section intermédiaire cylindrique (3") dudit trou traversant (3).

21. Dispositif de freinage comprenant une plaquette de frein (1) selon l'une quelconque des revendications précédentes et une unité de gestion d'énergie (12) connectée audit module thermoélectrique (6), ladite unité de gestion d'énergie (12) comprenant une commande logique (17), un circuit électrique d'alimentation (13) à une charge (14), et un accumulateur d'énergie (15) connecté audit circuit électrique d'alimentation (13), ledit circuit électrique d'alimentation (13) comprenant une pluralité de commutateurs (16) commutant entre un état de charge et un état de décharge, et ledit accumulateur d'énergie (15) comprend une pluralité de condensateurs (15'), et en ce que dans ledit état de charge lesdits commutateurs (16) connectent en parallèle lesdits condensateurs (15') et dans ledit état de décharge lesdits commutateurs (16) connectent en série lesdits condensateurs (15').
